# EUROPEAN PATENT APPLICATION

(11) **EP 4 471 189 A2**
(43) Date of publication of application: **04.12.2024**
(21) Application number: 23747197.4
(22) Date of filing: 06.01.2023
(51) Int. Cl.: C30B 11/00, C04B 35/653, B28B 1/54, C01B 25/18

(54) **METHOD FOR PREPARING CREMATION CRYSTALS BY USING CATALYST OBTAINED THROUGH REDUCTION OF PHOSPHORUS IN SKELETAL REMAINS**

(30) Priority: 26.01.2022 KR 20220011167
(71) Applicant: Ko, Mi Kyung, Jeju-si, Jeju-do 63105 (KR)
(72) Inventor: BOO, Se Ho, Jeju-si, Jeju-do 63105 (KR); KIM, Dae Hoon, Incheon 22681 (KR); KO, Mi Kyung, Jeju-si, Jeju-do 63105 (KR)
(74) Representative: González López-Menchero, Álvaro Luis
(86) International application number: PCT/KR2023/000296
(87) International publication number: WO 2023/146154

(57) **Abstract**

The objective of the present invention is to provide a method for preparing cremation crystals, the method using phosphoric acid extracted from cremated remains as a catalyst in the heat treatment of ashes so that transparent cremation crystals can be prepared only with components of skeletal remains derived from a single individual, and using only skeletal remains of a single individual through the control of the classification ratio of raw bone powder and phosphorus-extracted bone powder, and the like, so that the amount of phosphorus in the crystals is controlled, thereby enabling cremation crystals transparency to be controlled, and thus aesthetic requirements of consumers are satisfied and use as various kinds of jewelry is also facilitated.

## Description

### Technical Field

The present disclosure relates to a method of preparing a transparent cremation crystal using only a remains component derived from a single individual with a phosphoric acid extracted from cremated remains as a catalyst in a heat treatment process for bone powder. Only the remains of a single individual are used by adjusting the classification ratio of raw bone powder to phosphorus-extracted bone powder. By adjusting the phosphorus content in the crystal from the remains of a single individual, the transparency of the cremation crystal is controlled, resulting in meeting the aesthetic needs of consumers and making the cremation crystal into various types of jewelry.

### Background Art

Burial has traditionally been a main method of placing the dead body in Korea. In the case of graves created in this way, each grave occupies an average of about 15 pyeong (in which "pyeong" is a measurement unit representing about 3.3 square meters). According to statistics, land about half the size of Jeju Island is used as cemeteries in Korea. In addition, tombs created in this way are usually located in remote places or the mountains, so tomb management is quite difficult. These burial customs do not fit the current circumstances of Korea, in which a usable area is limited and land value continues to increase. In addition, as modern society has become more westernized, and nuclear families have become more common, social awareness of funeral customs has changed significantly. Accordingly, such types of customs are being rejected, and cremation has been gradually replacing them. Meanwhile, with the development of pet-rearing culture, the number of pets being cremated like humans after death continues to increase.

Meanwhile, the remains remaining after cremation are generally pulverized and placed in an ossuary in a bone powder form. The bone powder in an ossuary is then stored in a charnel house or an outdoor charnel house, which are stone structures. However, since deceased remains are burned at high temperatures, a porous structure with many fine pores is formed, resulting in the induction of very strong adsorption properties. Therefore, moisture absorption, foreign matter adsorption, or bacterial adsorption from the surrounding environment strongly occur during storage. Accordingly, there are problems of deteriorating and decaying remains, resulting in foul odor generation, and also damage to the remains due to pest invasion.

To solve these problems, techniques have been proposed for turning bone powder of a deceased person or pet into a relic or jewelry to preserve the bone powder by additionally processing the bone powder to increase its stability as well as to give the bone powder aesthetic value and storage properties. In the case of conventional bone powder reliquary processes, a gas direct-fired method or plasma method is usually used. In this case, a high temperature in a range of 1,800°C to 2,200°C is used. At such high temperatures, when the bone powder is melted, the bone powder becomes acidic and has the property of a high-melting point quencher. Using these properties, pebble-shaped relics are prepared. However, in this case, there is a problem in that not only does the loss of bone powder inevitably takes place due to oxidation in the direct-fired method and volatilization in the process of high temperatures, but there is also a high chance that the bone powder will deteriorate even after turning the bone powder into relics. In addition, in the case of conventional gem-making techniques, the proposed processes are for extracting only specific elements from bone powder and mixing the elements with rubies and sapphires for synthesis, or extracting carbon from bone powder to create artificial diamonds. However, even when the jewelry made in this way has good aesthetic functionality in terms of appearance, only a slight amount of elements are used as raw materials based on the entire bone powder. This concept does not quite fit for the Eastern funerary culture that emphasizes the preservation of remains. Thus, the problem of defeating the fundamental purposes of the techniques ultimately occurred.

### <Patent Document>

Korean Patent No. 10-1516149, published on May 4, 2015, titled "Burner Type an Ashes Molding Apparatus"

An apparatus for preparing a bead-shaped crystal by heat-treating bone powder and a method of preparing a crystal using the same are disclosed. However, there was a problem in that the remains could be lost due to volatilization during the heat-treatment of the remains at a high temperature of 1,800°C or higher.

### <Patent Document>

Korean Patent Application Publication No. 10-2013-0082462, published on July 19, 2013, titled "A Method for Conserving Mixed Composite of Charcoal Cremated Remains Crystalline Powder"

A method of preparing a cremation crystal with excellent preservative, deodorizing, and antibacterial effects has been disclosed. However, during the preparation process, a significant amount of substances such as charcoal, ceramics, lacquerware, and tourmaline were added, resulting in containment of low bone powder content in the cremation crystal.

### Disclosure

### Technical Problem

The present disclosure was devised to solve the problems.

The present disclosure is to provide a method of preparing a transparent cremation crystal using only a remains component derived from a single individual with a phosphoric acid extracted from cremated remains as a catalyst in a heat treatment process for bone powder. Only the remains of a single individual are used by adjusting the classification ratio of raw bone powder to phosphorus-extracted bone powder. By adjusting the phosphorus content in the crystal from the remains of a single individual, the transparency of the cremation crystal is controlled, resulting in meeting the aesthetic needs of consumers and making the cremation crystal into various types of jewelry.

### Technical Solution

To achieve the objective, the present disclosure is implemented by embodiments having the following configuration.

According to one embodiment of the present disclosure, the method of preparing a cremation crystal includes a mixing step of mixing bone powder with a catalyst to form a mixture; a drying step of drying the mixture to form a dried product; a subdividing step of pulverizing the dried product to form a pulverized product; a heat treatment step of melting the pulverized product through a heat treatment process to form a melt; and a crystallizing step of cooling the melt to form a cremation crystal. The catalyst in the mixing step is a phosphoric acid (H₃PO₄), and the phosphorus content is adjusted to control the transparency of the cremation crystal finally formed.

According to another embodiment of the present disclosure, the method of preparing a cremation crystal further includes a classification step of classifying the bone powder into raw bone powder and phosphorus-extracted bone powder; and a phosphoric acid acquisition step of obtaining a phosphoric acid from the phosphorus-extracted bone powder. The phosphoric acid used as the catalyst in the mixing step is the phosphoric acid obtained in the phosphoric acid acquisition step.

According to yet another embodiment of the present disclosure, in the method of preparing a cremation crystal, the phosphoric acid acquisition step involves extracting a phosphorus pentoxide from the phosphorus-extracted bone powder and hydrating the extracted phosphorus pentoxide in water to obtain the phosphoric acid.

According to yet another embodiment of the present disclosure, in the method of preparing a cremation crystal, the mixing step involves mixing the raw bone powder with the phosphoric acid obtained in the phosphoric acid acquisition step to form the mixture.

According to yet another embodiment of the present disclosure, in the method of preparing a cremation crystal, the mixing step involves adjusting a phosphorus content in the crystal by adjusting the classification ratio of the raw bone powder to the phosphorus-extracted bone powder when the mixture is formed, thereby the transparency of the cremation crystal finally formed is controlled.

According to yet another embodiment of the present disclosure, the method of preparing a cremation crystal further includes a phosphoric acid acquisition step of obtaining a phosphoric acid from the bone powder; and a recovering step of recovering a residual bone powder remaining after performing the phosphoric acid acquisition step. The mixing step involves forming the mixture by mixing the residual bone powder recovered in the recovering step by using the phosphoric acid as the catalyst.

According to yet another embodiment of the present disclosure, in the method of preparing a cremation crystal, the phosphoric acid mixed, as the catalyst, with the residual bone powder in the mixing step is the phosphoric acid obtained in the phosphoric acid acquisition step.

According to yet another embodiment of the present disclosure, the method of preparing a cremation crystal is characterized in that the transparency of the cremation crystal finally formed is controlled by adjusting the residual phosphorus content of the residual bone powder.

According to yet another embodiment of the present disclosure, in the method of preparing a cremation crystal, the phosphoric acid acquisition step includes a phosphorus reduction step of reducing phosphorus contained in the bone powder to extract the phosphorus from the bone powder; a combustion step of burning and oxidizing the extracted phosphorus to form an oxide; and a hydration step of reacting the oxide with water (H₂O) to obtain the phosphoric acid.

According to yet another embodiment of the present disclosure, in the method of preparing a cremation crystal, the heat treatment process involves melting the pulverized product by heat treatment for 10 minutes to 2 hours at a temperature in a range of 800°C to 1250°C.

### Advantageous Effects

The present disclosure can achieve the following effects through the combination and usage relationship with the configuration described in the preceding embodiments and the following description.

The present disclosure is to provide a method of preparing a transparent cremation crystal using only a remains component derived from a single individual with a phosphoric acid extracted from cremated remains as a catalyst in a heat treatment process for bone powder. Only the remains of a single individual are used by adjusting the classification ratio of raw bone powder to phosphorus-extracted bone powder. By adjusting the phosphorus content in the crystal from the remains of a single individual, the transparency of the cremation crystal is controlled, resulting in meeting the aesthetic needs of consumers and making the cremation crystal into various types of jewelry.

### Description of Drawings

FIG. 1 is a step diagram of a method of preparing a cremation crystal according to one embodiment of the present disclosure;
FIG. 2 is a step diagram showing the detailed steps of a phosphoric acid acquisition step in the method of preparing a cremation crystal according to another embodiment of the present disclosure;
FIG. is a step diagram showing the overall steps of the method of preparing a cremation crystal, including the phosphoric acid acquisition step;
FIG. 4 is a step diagram of a method of preparing a cremation crystal according to yet another embodiment of the present disclosure;
FIG. 5 is a step diagram of a method of preparing a cremation crystal according to yet another embodiment of the present disclosure;
FIGs. 6 to 8 are photographs of a cremation crystal prepared by a method of preparing a cremation crystal according to yet another embodiment of the present disclosure; and
FIG. 9 is a photograph of a cremation crystal prepared by a method of preparing a cremation crystal according to yet another embodiment of the present disclosure.

### Best Mode

Hereinafter, the method of preparing a cremation crystal according to the present disclosure will be described in detail with reference to the attached drawings. Unless otherwise specified, all terms in this specification have the same general meaning as understood by a person skilled in the art to which the present disclosure pertains. When there is a conflict with the meaning of the terms used in this specification, the definitions used in this specification shall apply. Additionally, detailed descriptions of well-known functions and configurations that may unnecessarily obscure the gist of the present disclosure will be omitted.

Unless otherwise defined, all terms (including technical and scientific terms) used in this specification may be used with meanings that can be commonly understood by those skilled in the art to which the present disclosure pertains. Additionally, terms defined in commonly used dictionaries are not interpreted ideally or excessively unless clearly specifically defined. Throughout the specification, when a part "includes" a certain component, this means that it may further include other components rather than excluding other components unless specifically stated to the contrary.

Meanwhile, bone powder generally refers to a material obtained by pulverizing remaining bone components from the remains of a vertebrate. However, the term "bone powder" in this specification is preferably understood to mean a material obtained by pulverizing remaining bone components after cremating the deceased or a dead companion animal or livestock animal.

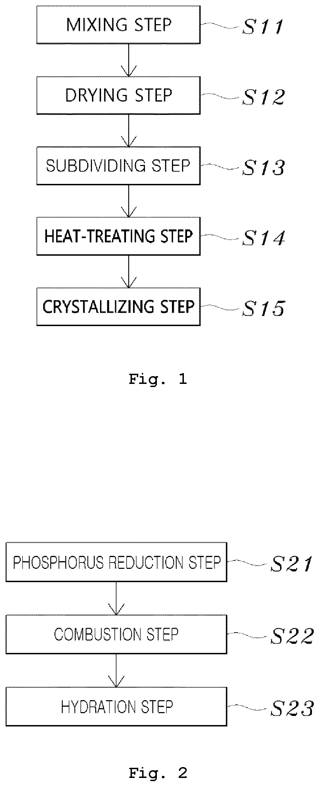

When a method of preparing a cremation crystal is explained according to one embodiment of the present disclosure with reference to FIG. 1, the method includes a mixing step S11 of mixing bone powder with a catalyst to form a mixture; a drying step S12 of drying the mixture to form a dried product; a subdividing step S13 of pulverizing the dried product to form a pulverized product; a heat treatment step S14 of melting the pulverized product through a heat treatment process to form a melt; and a crystallizing step S15 of cooling the melt to form a cremation crystal.

The mixing step S11 means uniformly mixing the bone powder with a catalyst to form a mixture. The mixing method of forming a mixture may be applied without particular restrictions. For example, in addition to known mechanical mixing methods (for example, ball mill, cutter mill, automatic trigger, bead mill, jet mill, and plate mill), mixing may also be easily performed manually. To form a mixture in a purer form, it is preferable to perform mixing using a mixing device made of material with chemical resistance such as quartz or Pyrex, but the mixing device is not necessarily limited thereto.

The catalyst is not particularly limited as long as the catalyst may be mixed with the bone powder to form a eutectic point lower than the melting temperature of the skeletal remains themselves. The catalyst preferably includes a silicon compound, a boron compound, a phosphorus compound, or a mixture thereof. More preferably, the catalyst includes a phosphorus compound selected from one or more of the groups consisting of a metaphosphoric acid (HPO₃), a pyrophosphoric acid (H₄P₂O₇), a phosphoric acid (H₃PO₄), phosphate compounds thereof, a phosphorus pentoxide (P₂O₅) or mixtures thereof. More preferably, the catalyst includes the phosphoric acid (H₃PO₄). The phosphoric acid may serve as a flux to lower the eutectic point in the process of melting the bone powder. At the same time, the phosphoric acid may play a significant role in forming a crystal by activating phosphorus in the bone powder on the basis of the crystallizing property, the activation occurring in proportion to an increase in the concentration of the phosphoric acid. The phosphoric acid may also play a role in preventing bone powder loss which is caused by volatilization under high-temperature conditions and is one of the main problems in the melting process. Additionally, the transparency of the cremation crystal finally formed may be controlled depending on the phosphorus content in the bone powder.

In the mixing step S11, the catalyst is a phosphoric acid as described above. The phosphoric acid as the catalyst preferably means a phosphoric acid in an 85% aqueous solution. The catalyst is subjected to mixing in an amount of 100 parts to 200 parts by weight based on 100 parts by weight of the bone powder. Preferably, the catalyst is subjected to mixing in an amount of 100 parts to 180 parts by weight based on 100 parts by weight of the bone powder. More preferably, the catalyst is subjected to mixing in an amount of 160 parts by weight based on 100 parts by weight of the bone powder. When the catalyst is subjected to mixing in an amount of 100 parts by weight or less based on 100 parts by weight of the bone powder, a crystal is not formed because the bone powder is not sufficiently melted. When the catalyst is subjected to mixing in an amount of 200 parts by weight or more based on 100 parts by weight of the bone powder, due to the excessive phosphorus content, the melt erupts out of the melt mold during the subsequent heat treatment process, or separation between the melt mold and crystal is not ensured after crystallization. Ultimately, the final shape of the crystal obtained is different from the normal shape and has a flat shape, thereby aesthetic functionality also deteriorates. Meanwhile, in the mixing step S11, 20 parts to 60 parts by weight of distilled water may be further added based on 100 parts by weight of the bone powder for a smoother reaction between the bone powder and the catalyst.

In the drying step S12, the uniform mixture formed in the mixing step S11 is dried under high-temperature conditions, preferably at a temperature in a range of 300°C to 600°C to form a dried product. However, it is preferable to perform drying by appropriately setting the drying temperature or drying time depending on the amount of the mixture and the state of the mixture. When the drying is carried out insufficiently or excessively than necessary, the shape or transparency of the crystal formed later may be affected.

In the subdividing step S13, the dried product formed in the drying step S12 is pulverized to form a pulverized product. Since the dried product that has been completely dried in the drying step S12 exists in a tightly hardened form like cement, the dried product is required to be subdivided to obtain small-sized pulverized products for melting. Various known pulverizing methods may be used as the pulverizing method used in the subdividing step S13. However, to minimize the loss of pulverized product due to the pulverization, it is preferable to use one or more methods selected from a disk mill, ball mill, or cutter mill. The formed pulverized product preferably has a size of 80 to 120 mesh, and more preferably has a size of 100 mesh.

In the heat treatment step S14, the pulverized product formed in the subdividing step S13 is melted through a heat treatment process to form a melt. In the heat treatment process, the pulverized product is put into a prepared melt mold and then the pulverized product is melted through heat treatment. The shape of the formed crystal varies depending on the shape of the melt mold, so the shape of the melt mold may be arbitrarily selected depending on the shape of the crystal to be prepared. The melt mold preferably includes a ceramic material selected from one or more selected from the groups consisting of alumina, zirconia, mullite, and quartz. Alternatively, the melt mold preferably includes a metal material selected from one or more of the metals frequently used as mold metals, such as platinum or nickel, or includes graphite. To form the shape of the crystal and smoothly separate the crystal from the melt mold, it is more preferable that the melt mold material is graphite.

The heat treatment method used in the heat treatment process is not particularly limited as long as the method is a commonly used heat treatment method. However, it is preferable to use a heat treatment method using a general electric furnace in terms of economic efficiency, ease of handling, and equipment costs.

The heat treatment process is preferably performed by melting the pulverized product in the electric furnace at a temperature in a range of 800°C to 1250°C for 10 minutes to 2 hours. When the heat treatment temperature is lower than 800°C, the pulverized product may not be sufficiently melted, making it difficult to effectively prepare a crystal. When the heat treatment temperature is higher than 1250°C, melting of the pulverized product is achieved relatively effectively, but more energy than necessary is used. Thus, the excessive temperature causes the problem of having to separately employ special equipment for high temperatures in addition to the cost increase. In addition, when the heat treatment time is less than 10 minutes under the heat treatment temperature conditions, the pulverized product may not be sufficiently melted, making it difficult to effectively prepare a crystal. When the heat treatment time exceeds 2 hours, more energy than necessary is used. Thus, in addition to the problems that arise, the quality of the final crystal deteriorates as the melt mold is excessively oxidized. It is preferable that the heat treatment time is appropriately selected within the time range depending on the size or shape of the crystal to be prepared.

To describe the performance of the heat treatment process in more detail, the pulverized product to be melted is added when the electric furnace has a temperature in a range of 700°C to 900°C. The temperature is raised to a predetermined target temperature within the heat treatment temperature range. Afterward, depending on the size and shape of the target crystal, the target temperature is maintained for a predetermined time within the heat treatment time range, thereby the heat treatment process is performed.

In the crystallizing step S15, the melt that has undergone the heat treatment process in the heat treatment step S14 is cooled to form a cremation crystal. When the heat treatment process is completed, the temperature inside the electric furnace is lowered, and when the discharge temperature is reached through temperature reduction, the melt mold is discharged to the outside of the electric furnace. When the melt mold is discharged to the outside of the electric furnace at a low temperature of about 750°C or lower, porcelainization occurs in the crystal. Accordingly, the discharge temperature is in a range of 750°C to 950°C, preferably 800°C to 900°C.

The method of preparing a cremation crystal according to another embodiment of the present disclosure may further include a separation and washing step (not shown) after the crystallizing step S15. The separation and washing step involves additionally cooling the melt mold discharged from the electric furnace, separating the crystal from the melt mold, and removing foreign substances such as melt mold powder present on the surface of the crystal. At this time, when the crystal separation is performed while the melt mold temperature is maintained at 100°C or more, the crystal shape is distorted. In addition, crystal breakage may occur during the washing process. Thus, it is preferable to separate the crystal from the melt mold while the melt mold temperature is maintained in the temperature range of 10°C to 100°C. The washing method is not particularly limited, but washing using ultrasonic waves is preferred to maintain the crystal shape and minimize scratch occurrence.

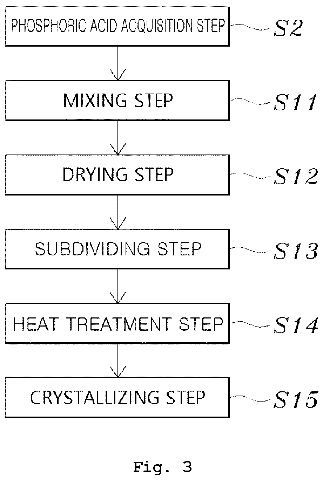

Hereinafter, the phosphoric acid acquisition step S2 in the method of preparing a cremation crystal according to the present disclosure will be described with reference to FIGS. 2 and 3. The phosphoric acid acquisition step S2 in the method of preparing a cremation crystal according to the present disclosure includes a phosphorus reduction step S21 of reducing phosphorus contained in the bone powder to extract the phosphorus from the bone powder; a combustion step S22 of burning and oxidizing the extracted phosphorus to form an oxide; and a hydration step S23 of reacting the oxide with water to obtain the phosphoric acid.

The remains have some differences depending on the species but are generally known to have a composition of 55.82% calcium oxide (CaO), 42.39% phosphorus pentoxide (P₂O₅), and 1.79% water. The atomic weight of phosphorus (P) is 30.9738 g/mol, so when calculated based on this, the phosphorus content in the remains accounts for about 25% to 30% of the total weight. Thus, the remains themselves may be an excellent source of phosphorus, and the quality of the obtained phosphorus compounds is not inferior at all to those obtained by the commonly used methods of obtaining phosphorus compounds from phosphate ore. Thus, the method of preparing a cremation crystal according to the present disclosure may reduce preparation costs by further including a phosphoric acid acquisition step S2 of obtaining a phosphoric acid from the bone powder itself.

The phosphorus reduction step S21 means extracting phosphorus from remains. The extraction method is not particularly limited to any of the various known conventional extraction methods. However, the extraction method preferably involves using a tubular electric furnace that may freely create the gas atmosphere under an inert atmosphere such as argon or helium or a reducing atmosphere such as nitrogen, hydrogen, carbon dioxide, or carbon monoxide gas to minimize oxidation due to heating, and the extraction method preferably involves reducing phosphorus from the remains to extract the phosphorus.

In the combustion step S22, the phosphorus extracted in the phosphorus reduction step S21 is burned and oxidized to form an oxide. The oxide refers to various types of compounds in which phosphorus is oxidized but preferably refers to phosphorus pentoxide (P₂O₅). When phosphorus is burned, the phosphorus is oxidized to generally form a phosphorus pentoxide (P₂O₅), and the reaction formula is as follows.

[Reaction formula 1] P₄ + 5O₂ → 2P₂O₅

The method of performing the combustion process in the combustion step S22 is not particularly limited as long as the method is a known combustion method.

In the hydration step S23, the oxide formed in the combustion step S22 is reacted with water to obtain a phosphoric acid. As mentioned above, the oxide is preferably a phosphorus pentoxide, and when the phosphorus pentoxide reacts with water, the phosphorus pentoxide forms a phosphoric acid, the reaction formula is as follows.

[Reaction formula 2] P₂O₅ + 3H₂O → 2H₃PO₄

Therefore, the method of preparing a cremation crystal including the phosphoric acid acquisition step S2 is described in more detail through a time series method as follows. The method includes the phosphoric acid acquisition step S2 to obtain a phosphoric acid, the phosphoric acid acquisition step S2 including the phosphorus reduction step S21; the combustion step S22; and the hydration step S23; a mixing step S11 of mixing the phosphoric acid obtained in the phosphoric acid acquisition step with bone powder; a drying step S12 of drying the mixture to form a dried product; a subdividing step S13 of pulverizing the dried product to form a pulverized product; a heat treatment step S14 of melting the pulverized product through a heat treatment process to form a melt; and a crystallizing step S15 of cooling the melt to form a cremation crystal. By the method, a cremation crystal is prepared. Detailed descriptions of the mixing step S11, drying step S12, subdividing step S13, heat treatment step S14, and crystallizing step S15 are the same as described above, so the detailed descriptions will be omitted below.

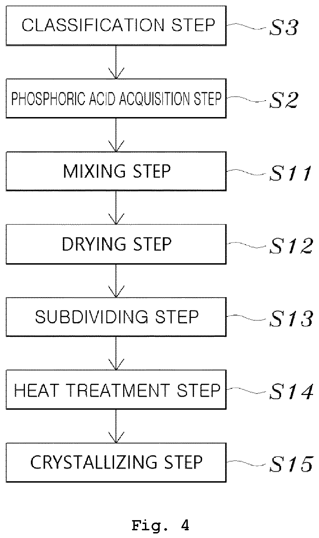

Hereinafter, a method of preparing a cremation crystal according to yet another embodiment of the present disclosure will be described with reference to FIG. 4. According to yet another embodiment, the method of preparing a cremation crystal further includes a classification step S3 of classifying the bone powder into raw bone powder and phosphorus-extracted bone powder; and a phosphoric acid acquisition step S2 of obtaining a phosphoric acid from the phosphorus-extracted bone powder. The phosphoric acid used as the catalyst in the mixing step is the phosphoric acid obtained in the phosphoric acid acquisition step. Furthermore, the mixing step involves mixing the phosphoric acid obtained in the phosphoric acid acquisition step and the raw bone powder to form a second mixture.

In the classification step S3, prior to the preparation process of the cremation crystal according to yet another embodiment of the present disclosure described above, the bone powder to be used for preparing a cremation crystal is classified into raw bone powder and phosphorus-extracted bone powder. The raw bone powder refers to the bone powder classified as a mixing subject in the mixing step S11 after the classification step S3. It is preferable that the raw bone powder be stored appropriately after the classification until the raw bone powder is used in the mixing step 511. The storage method is not particularly limited as long as it is a storage method that does not affect the physical or chemical properties of the bone powder. Meanwhile, the phosphorus-extracted bone powder refers to bone powder classified as a bone powder input to obtain a phosphoric acid in the phosphoric acid acquisition step S2. Detailed descriptions of the method of obtaining the phosphoric acid from the phosphorus-extracted bone powder through the process of reducing, burning, and hydrating the phosphorus-extracted bone powder are the same as described above and will therefore be omitted. Meanwhile, the second mixture to be obtained in the mixing step S11 refers to a mixture of a phosphoric acid obtained in the phosphoric acid acquisition step S2 and the raw bone powder, as described above.

Meanwhile, the phosphoric acid that may be obtained from bone powder has almost the same mass as the bone powder added. As mentioned above, the phosphorus content in the remains accounts for about 25% to 30% of the total weight of the remains. As described above, the atomic weight of phosphorus is 30.9738 g/mol, the atomic weight of oxygen (O) is 15.999 g/mol, and the atomic weight of hydrogen (H) is 1.008 g/mol. One phosphate molecule contains 3 hydrogen atoms, 4 oxygen atoms, and 1 phosphorus atom. Considering the atomic weights of phosphorus, oxygen, and hydrogen, the mass percentage (%) of phosphorus in one phosphoric acid molecule is approximately 31.6%. When calculation is performed with the values together, it is concluded that the phosphoric acid ultimately obtained has almost the same mass as the bone powder added. Therefore, based on this point, as described above, the preferred mixing ratio in the mixing step S11 in the method of preparing a cremation crystal according to the present disclosure is 100 parts to 200 parts by weight of the catalyst relative to 100 parts by weight of bone powder. More preferably, the ratio is 100 parts to 180 parts by weight of the catalyst relative to 100 parts by weight of bone powder, and even more preferably, the ratio is 160 parts by weight of the catalyst relative to 100 parts by weight of bone powder. Accordingly, it is preferable that the classification ratio of the raw bone powder to the phosphorus-extracted bone powder also follows the weight part ratio described above.

Therefore, according to yet another embodiment of the present disclosure, the method of preparing a cremation crystal is described in more detail through a time series method as follows. The method includes first the classification step S3 of classifying bone powder into raw bone powder and phosphorus-extracted bone powder; the phosphoric acid acquisition step S2 of obtaining the phosphoric acid using the phosphorus-extracted bone powder; a mixing step S11 of mixing the obtained phosphoric acid and the raw bone powder to form a second mixture; a drying step S12 of drying the second mixture to form a dried product; a subdividing step S13 of pulverizing the dried product to form a pulverized product; a heat treatment step S14 of melting the pulverized product through a heat treatment process to form a melt; and a crystallizing step S15 of cooling the melt to form a cremation crystal. By the method, a transparent cremation crystal is ultimately prepared. Detailed descriptions of the phosphoric acid acquisition step S2, drying step S12, subdividing step S13, heat treatment step S14, and crystallizing step S15 are the same as described above, so the descriptions will be omitted below. In the case of the mixing step S11, there is a difference from the above in that the phosphoric acid obtained through the phosphoric acid acquisition step S2 and the raw bone powder are mixed to form a second mixture. However, the detailed mixing method of forming the second mixture is no different from the mixing method described above, so the description for this will also be omitted below.

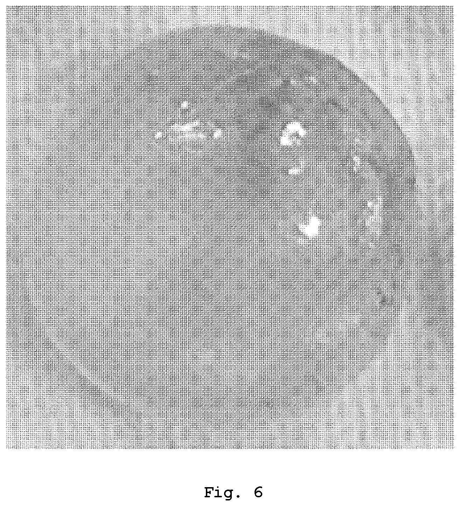

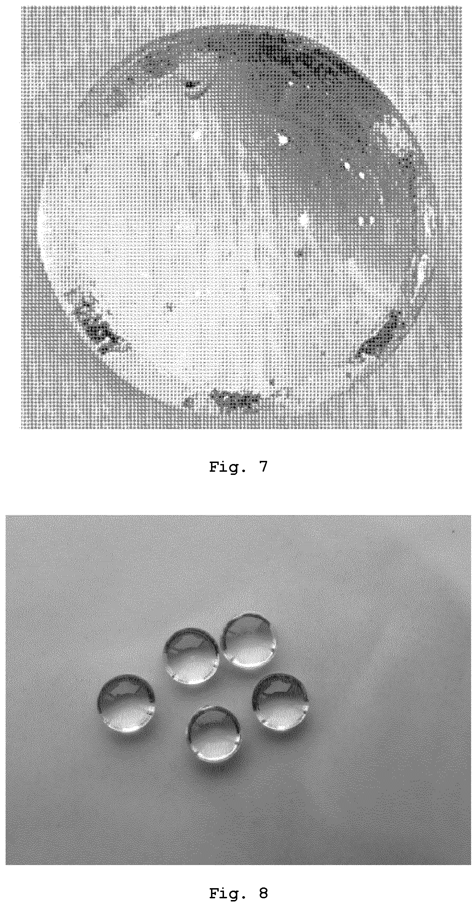

In preparing a cremation crystal by the method of preparing a cremation crystal according to yet another embodiment of the present disclosure, a cremation crystal may be prepared by classifying bone powder into raw bone powder and phosphorus-extracted bone powder and then mixing a phosphoric acid extracted from the phosphorus-extracted bone powder with the raw bone powder. Accordingly, a transparent cremation crystal may be prepared by using only the remains of a single individual without the need to add additional substances. By forming the cremation crystal, this technique enables to satisfy the fundamental intention and needs of bereaved families or guardians who wish to commemorate the deceased, deceased pets or livestock, and preserve the remains. At the same time, the technique enables to prepare a cremation crystal with excellent aesthetic value. At this time, the ratio of the raw bone powder to the phosphorus-extracted bone powder may be adjusted to adjust the content of phosphorus present in the crystal. When the phosphorus content is adjusted, the transparency of the transparent cremation crystal finally formed may be freely controlled. Through this, it is possible to accurately realize and provide the transparency desired by the recipient. For example, when the ratio of the raw bone powder to the phosphorus-extracted bone powder is adjusted so that the content of phosphorus present in the crystal is approximately 30% to 40%, an opaque crystal may be obtained. When the phosphorus content is approximately 40% to 50%, a translucent crystal may be obtained, and when the phosphorus content is approximately 50% to 60%, a completely transparent crystal may be obtained. FIGs. 6 and 7 show photographs of crystals prepared by the method of preparing a cremation crystal according to yet another embodiment of the present disclosure, in which the contents of phosphorus present in the crystals are different by adjusting the ratio of the raw bone powder to the phosphorus-extracted bone powder. As a result of component analysis of the crystal using XRF-ED, the phosphorus content of the translucent crystal shown in FIG. 6 was 48%, and the phosphorus content of the completely transparent crystal shown in FIG. 7 was 53%. Through this, the more transparent the crystal, the higher the phosphorus content.

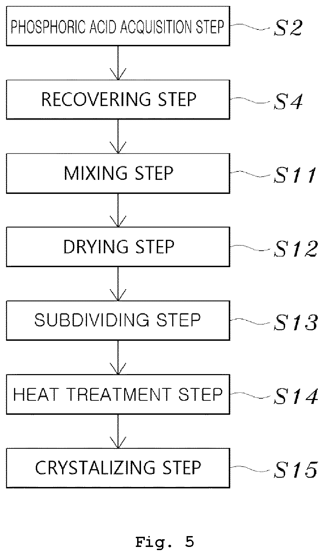

Hereinafter, a method of preparing a cremation crystal according to yet another embodiment of the present disclosure will be described with reference to FIG. 5. The method of preparing a cremation crystal according to yet another embodiment of the present disclosure may further include a recovering step S4 of recovering the residual bone powder remaining after performing the phosphoric acid acquisition step S2. The mixing step S11 involves forming a third mixture by mixing the residual bone powder recovered in the recovering step S4 with phosphoric acid as a catalyst. Preferably, the phosphoric acid mixed, as the catalyst, with the residual bone powder in the mixing step S11 is the phosphoric acid obtained in the phosphoric acid acquisition step S2.

In the recovering step S4, the phosphorus component is extracted through the phosphoric acid acquisition step S2, and the remaining residual bone powder is recovered. Meanwhile, the third mixture obtained in the mixing step S11 refers to a mixture of the residual bone powder and a phosphoric acid as a catalyst or of the residual bone powder and a phosphoric acid obtained in the phosphoric acid acquisition step S2, as described above.

Therefore, according to yet another embodiment of the present disclosure, the method of preparing a cremation crystal is described in more detail through a time series method as follows. The method includes first the phosphoric acid acquisition step S2 of obtaining a phosphoric acid using the bone powder; a recovering step S4 of recovering the residual bone powder remaining after extracting a phosphorus component through the phosphoric acid acquisition step S2; a mixing step S11 of mixing the recovered residual bone powder with the phosphoric acid obtained in the phosphoric acid acquisition step S2 to form a third mixture; a drying step S12 of drying the mixture to form a dried product; a subdividing step S13 of pulverizing the dried product to form a pulverized product; a heat treatment step S14 of melting the pulverized product through a heat treatment process to form a melt; and a crystallizing step S15 of cooling the melt to form a cremation crystal. By the method, an opaque cremation crystal is ultimately prepared. Detailed descriptions of the phosphoric acid acquisition step S2, drying step S12, subdividing step S13, heat treatment step S14, and crystallizing step S15 are the same as described above, so the descriptions will be omitted below. In the case of the mixing step S11, there is a difference from the above in that a third mixture is formed by mixing the residual bone powder with a phosphoric acid as a catalyst or a phosphoric acid obtained through the phosphoric acid acquisition step S2. However, the third mixture differs from the mixture and the second mixture only in terms of components, the mixtures being formed in a mixing step included in a method of preparing a cremation crystal according to an embodiment of the present disclosure or a method of preparing a cremation crystal according to another embodiment of the present disclosure. The detailed mixing method of forming the mixtures is no different from the mixing methods described above. Therefore, this will also be omitted below.

In preparing a cremation crystal by the method of preparing a cremation crystal according to yet another embodiment of the present disclosure, a cremation crystal may be prepared by extracting a phosphoric acid from the entire bone powder and then mixing the extracted phosphoric acid with the entire residual bone powder again. Accordingly, an opaque cremation crystal may be prepared by using only the remains of a single individual without the need to add additional substances. By forming the cremation crystal, this technique enables to satisfy the fundamental intention and needs of bereaved families or guardians who wish to commemorate the deceased, deceased pets or livestock, and preserve the remains. At the same time, the technique enables to prepare a cremation crystal with excellent aesthetic value.

Meanwhile, the cremation crystal prepared using the residual bone powder from which the phosphorus component has been extracted according to the method of preparing a cremation crystal according to yet another embodiment of the present disclosure has an opaque property, unlike a cremation crystal prepared using bone powder from which the phosphorus component has not been extracted. This means that the composition of the remains is the same as the composition of the cremation crystal described in the detailed description of the method of preparing a cremation crystal according to yet another embodiment of the present disclosure, so the residual bone powder remaining after the phosphorus component is extracted usually has only the composition of calcium, oxygen, and hydrogen. The third mixture formed using this in the mixing step S11 has a lower phosphorus content than the mixture or the second mixture. Ultimately, it is concluded that the content of the phosphorus component contained in the ultimately formed cremation crystal is relatively lower than the cremation crystal prepared according to the preparation method according to one embodiment or another embodiment of the present disclosure described above.

Therefore, adjusting the residual phosphorus content of the residual bone powder may result in freely controlling the transparency of the ultimately formed bone powder crystal. In the phosphoric acid acquisition step S2, the phosphorus component from bone powder is reduced through the phosphorus reduction step S21. Accordingly, adjusting the residual phosphorus content of the residual bone powder by adjusting the phosphorus reduction process in the phosphorus reduction step S21 may result in freely realizing the transparency of the ultimately formed cremation crystal. The method of adjusting the residual phosphorus content of the residual bone powder is not particularly limited as long as it is a method of adjusting the reduction process that may be used in various existing extraction methods. As described above, when the phosphorus reduction step S21 is performed using a tubular electric furnace that may freely create an inert atmosphere or a reducing atmosphere, the residual phosphorus content of the residual bone powder may be adjusted by adjusting the amount of reducing gas introduced to create the reducing atmosphere, adjusting the process time of reducing the bone powder in the electric furnace, or adjusting the internal temperature of the electric furnace.

Hereinafter, preferred examples are presented to aid understanding of the present disclosure. However, the following examples are provided only to make the present disclosure easier to understand, and the content of the present disclosure is not limited by the examples.

### <Example 1>

100 ml of commercially available 85% phosphoric acid aqueous solution per 100 g of pig bone powder obtained after cremation was stirred at a high speed of 1000 RPM for 2 minutes to form a mixture. Next, the formed mixture was dried at a temperature of 450°C for 20 minutes to form a dried product. The dried material was pulverized to a size of 100 mesh and then placed into a melt mold. The melt mold was placed in an electric furnace at a temperature of 700°C and then heated to a temperature of 1000°C over 1 hour. After heat treatment at the temperature for 20 minutes, the electric furnace was cooled to 800°C and then naturally cooled to room temperature. Bead-shaped crystals were separated from a cooled melt mold, and then after washing the crystals with ultrasonic waves, transparent bead-shaped crystals were obtained.

### <Example 2>

1. 200g of pig bone powder obtained after cremation was classified into 85g of raw bone powder and 115g of phosphorus-extracted bone powder. The 115 g of the phosphorus-extracted bone powder was placed in an electric furnace at a temperature of 1,350°C, nitrogen and hydrogen gas were added, and reduction was performed. The phosphorus thus obtained was burned and then reacted with flowing water to obtain about 110 g of liquid phosphoric acid. 25 g of distilled water was added to the liquid phosphoric acid to obtain about 135 g of an 85% phosphoric acid aqueous solution. In the process of obtaining phosphoric acid, the residual bone powder left in the electric furnace after reduction was separated and stored separately.
2. Other conditions were the same as in Example 1 except that raw bone powder separately classified in Example 2-1 was used instead of pig bone powder, and the phosphoric acid aqueous solution obtained in Example 2-1 was used instead of the commercially available phosphoric acid aqueous solution. Afterward, transparent bead-shaped single crystal agents 1 as shown in FIG. 8 were obtained.

### <Example 3>

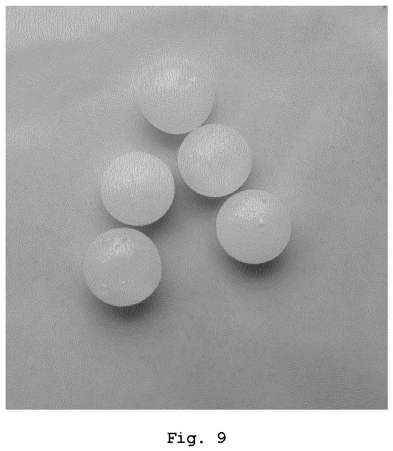

Other conditions were the same as in Example 1 except that the residual bone powder separated and stored separately in Example 2-1 was used instead of pig bone powder, and the phosphoric acid aqueous solution obtained in Example 2-1 was used instead of the commercially available phosphoric acid aqueous solution. Afterward, opaque bead-shaped single crystal agents 2 as shown in FIG. 9 were obtained.

### <Comparative Example 1>

An attempt was made to prepare crystals when other conditions were the same as in Example 1 except that the process of drying pig bone powder only was started immediately without mixing a phosphoric acid solution and pig bone powder. However, the pulverized product did not melt properly, so ultimately, bead-shaped cremation crystals were not obtained.

### <Comparative Example 2>

An attempt was made to prepare crystals when other conditions were the same as in Example 1 except that only 50 ml of phosphoric acid aqueous solution was used instead of 100 ml of the solution. However, in this case, the pulverized product did not melt properly, so ultimately, bead-shaped cremation crystals were not obtained.

### <Comparative Example 3>

An attempt was made to prepare crystals when other conditions were the same as in Example 1 except that only 150 ml of phosphoric acid aqueous solution was used instead of 100 ml of the solution. However, in this case, the crystals were not properly separated from the melt mold, so ultimately, bead-shaped cremation crystals were not obtained.

### <Comparative Example 4>

An attempt was made to prepare crystals when other conditions were the same as in Example 1 except that heat treatment was performed at a temperature of 750°C for 30 minutes unlike Example 1. However, in this case, the pulverized product did not melt properly, so ultimately, bead-shaped cremation crystals were not obtained.

Herein above, the applicant has described various examples of the present disclosure, but such embodiments are only examples that implement the technical idea of the present disclosure, and any changes or modifications should be construed as falling within the scope of the present disclosure as long as the changes or modifications implement the technical idea of the present disclosure.

## Claims

1. A method of preparing a cremation crystal, the method comprising:
a mixing step of mixing bone powder with a catalyst to form a mixture;
a drying step of drying the mixture to form a dried product;
a subdividing step of pulverizing the dried product to form a pulverized product;
a heat treatment step of melting the pulverized product through a heat treatment process to form a melt; and
a crystallizing step of cooling the melt to form a cremation crystal,
wherein the catalyst in the mixing step is a phosphoric acid (H₃PO₄), and
a phosphorus content is adjusted to control the transparency of the cremation crystal finally formed.

2. The method of claim 1, further comprising:
a classification step of classifying the bone powder into raw bone powder and phosphorus-extracted bone powder; and
a phosphoric acid acquisition step of obtaining a phosphoric acid from the phosphorus-extracted bone powder,
wherein the phosphoric acid used as the catalyst in the mixing step is the phosphoric acid obtained in the phosphoric acid acquisition step.

3. The method of claim 2, wherein the phosphoric acid acquisition step comprises:
extracting a phosphorus pentoxide from the phosphorus-extracted bone powder; and
hydrating the extracted phosphorus pentoxide in water to obtain the phosphoric acid.

4. The method of claim 2, wherein the mixing step comprises mixing the raw bone powder with the phosphoric acid obtained in the phosphoric acid acquisition step to form the mixture.

5. The method of claim 4, wherein the mixing step comprises adjusting a phosphorus content in the crystal by adjusting the classification ratio of the raw bone powder to the phosphorus-extracted bone powder when the mixture is formed, thereby the transparency of the cremation crystal finally formed is controlled.

6. The method of claim 1, further comprising:
a phosphoric acid acquisition step of obtaining a phosphoric acid from the bone powder; and
a recovering step of recovering a residual bone powder remaining after performing the phosphoric acid acquisition step,
wherein the mixing step involves forming the mixture by mixing the residual bone powder recovered in the recovering step by using the phosphoric acid as the catalyst.

7. The method of claim 6, wherein the phosphoric acid mixed, as the catalyst, with the residual bone powder in the mixing step is the phosphoric acid obtained in the phosphoric acid acquisition step.

8. The method of claim 7, wherein the method is **characterized in that** the transparency of the cremation crystal finally formed is controlled by adjusting the residual phosphorus content of the residual bone powder.

9. The method of claim 8, wherein the phosphoric acid acquisition step comprises:
a phosphorus reduction step of reducing phosphorus contained in the bone powder to extract the phosphorus from the bone powder;
a combustion step of burning and oxidizing the extracted phosphorus to form an oxide; and
a hydration step of reacting the oxide with water (H₂O) to obtain the phosphoric acid.

10. The method of claim 1, wherein the heat treatment process comprises melting the pulverized product by heat treatment for 10 minutes to 2 hours at a temperature in a range of 800°C to 1250°C.
